(19) Europäisches Patentamt
European Patent Office
Office européen des brevets

(11) **EP 2 320 469 A1**

(12) **DEMANDE DE BREVET EUROPEEN**

(43) Date de publication:
**11.05.2011 Bulletin 2011/19**

(51) Int Cl.:
***H01L 31/0352*** *(2006.01)*

(21) Numéro de dépôt: **10305911.9**

(22) Date de dépôt: **24.08.2010**

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**
Etats d'extension désignés:
**BA ME RS**

(30) Priorité: **06.11.2009 FR 0957883**

(71) Demandeur: **Commissariat à l'Énergie Atomique et aux Énergies Alternatives
75015 Paris (FR)**

(72) Inventeurs:
• **Fendler, Manuel
38000, GRENOBLE (FR)**
• **Dumas, Delphine
38000, GRENOBLE (FR)**

(74) Mandataire: **Vuillermoz, Bruno et al
Cabinet Laurent & Charras
"Le Contemporain"
50, Chemin de la Bruyère
69574 Dardilly Cédex (FR)**

(54) **Procédé de réalisation d'un circuit courbe**

(57) L'invention concerne un procédé de réalisation d'un circuit courbé (10). Selon l'invention, ce procédé consiste :

■ à former, dans une face dudit circuit (10) et selon au moins une direction prédéterminée, des tranchées (16) de section transversale triangulaire, parallèles entre elles et débouchant de part et d'autre dudit circuit (10) ;

■ à déposer une colle (20) sur les flancs des tranchées (16) ainsi réalisées ; et

■ à rapprocher les flancs des tranchées (16) de manière à fermer celle-ci.

Fig. 4

**Description**

## DOMAINE DE L'INVENTION

L'invention a trait aux circuits électroniques courbés et plus particulièrement aux détecteurs de rayonnements électromagnétiques quel que soit leur domaine spectral.

## ETAT DE LA TECHNIQUE

Que ce soit en photographie ou en vidéo, la formation d'images numériques est aujourd'hui encore réalisée sur des capteurs plans, essentiellement pour des raisons historiques liées à la forme plane des films analogiques ainsi qu'au parc optique existant des fabricants. L'essentiel des recherches a ainsi porté sur l'augmentation de la résolution en nombre d'éléments unitaires de détection, ou pixels, ainsi que la gestion du bruit numérique provoqué par des gains importants d'amplification de signal.

Toutefois, l'utilisation de capteurs plans a pour conséquence directe un certain nombre d'aberrations, tant géométriques que chromatiques, au rang desquels figurent les distorsions en barillet et en coussinet, les aberrations sphériques (ou aberrations dites de « lumière diffuse »), le coma, l'astigmatisme, le vignettage, les éblouissements, la lumière parasite (reflet), ou encore les franges chromatiques. De telles aberrations nécessitent d'être corrigées, directement lors de la formation des images par l'utilisation d'optiques complexes, et/ou à posteriori par la mise en oeuvre d'algorithmes de traitement d'images nécessitant d'importantes puissances de calcul. Ainsi, la nature plane des capteurs induit directement des aberrations et la correction de celles-ci implique des objectifs encombrants et couteux ainsi que des calculateurs puissants embarqués dans les caméras et les appareils photographiques numériques.

De telles aberrations disparaissent cependant lorsque le capteur prend une forme sphérique, proche de celle d'un oeil animal. Le fait de pouvoir courber le capteur permet donc, non seulement de corriger les aberrations, mais également de concevoir des caméras et des appareils photographiques compacts et bon marché et ne nécessitant pas de grande puissance de calcul, le tout accompagnée d'une acuité visuelle augmentée pouvant aller jusqu'au 180° pour les objectifs de type fisheye.

On conçoit donc aisément l'intérêt de concevoir des capteurs courbés dans le domaine de la formation d'image.

Les capteurs courbés présentent également un intérêt dans d'autres domaines, comme par exemple en spectrométrie optique. Ainsi, il est connu que les spectromètres optiques forment une image de diffraction sur une surface sphérique. Le réglage d'un spectromètre optique consiste alors pour l'essentiel à optimiser la position du capteur plan par rapport à la surface sphérique de formation de l'image de diffraction, et à gérer le décalage entre les deux. Le document « Concept of a miniature optical spectrometer using integrated optical and micro-optical components » d'Ivan Avratusky et al., Applied Optics, vol.45, n°30, octobre 2006, permet de comprendre les difficultés engendrées par un capteur plan dans le domaine de la spectrométrie optique. La réalisation d'un capteur courbé permettrait ainsi de positionner de manière idéale la détection au niveau de cette surface sphérique.

Usuellement, les capteurs numériques, quelle que soit leur technologie (CCD ou CMOS pour le visible, à base de CdHgTe pour l'infrarouge, etc...), et leur configuration (monolithique, hybridé, etc...) comprennent un substrat dans lequel est formé un circuit de lecture des pixels, ce substrat présentant une épaisseur de quelques dizaines de micromètres à plusieurs millimètres.

Or, la réalisation d'un substrat courbé, ou plus généralement la réalisation d'un circuit souple, restent difficile pour de telles épaisseurs.

En effet, courber un circuit plan présentant une épaisseur élevée (typiquement supérieure à 50 micromètres), et ayant donc une rigidité élevée, provoque des défauts nuisant à la qualité du circuit, comme par exemple des bourrelets, des fêlures, des déchirures, voire même la destruction de connexions et de composants électriques contenus dans le circuit.

Pour éviter de tels inconvénients, il est possible de concevoir un circuit ayant une épaisseur très faible (typiquement inférieure à 50 micromètres), et par conséquent une grande souplesse, puis de coller celui-ci sur un support présentant la courbure souhaitée.

Toutefois, la manipulation d'un circuit présentant une épaisseur très faible rend délicate sa manipulation, ce qui nécessite des dispositifs de préhension onéreux. En outre, le moindre défaut (poussière, bulle, inhomogénéité de la colle...) présent sur une surface venant au contact du circuit, que cela soit un défaut de surface des dispositifs de préhension ou du support recevant le circuit, se reporte sur ce dernier, diminuant ainsi la qualité du circuit, détériorant son fonctionnement, voire même détruisant des connexions ou composants électriques contenus dans celui-ci. La manipulation d'un circuit d'épaisseur très faible nécessite donc des mesures de protection particulièrement onéreuses.

## EXPOSE DE L'INVENTION

La présente invention vise à résoudre les problèmes susmentionnés en proposant un procédé permettant de courber un circuit, initialement plan et ayant une épaisseur importante permettant de conserver une rigidité mécanique suffisante pour être manipulé aisément.

A cet effet, l'invention a pour objet un procédé de fabrication d'un circuit courbé, consistant :

- à former dans une face dudit circuit et selon au moins une direction prédéterminée, des tranchées triangulaires parallèles débouchant de part et d'autre dudit circuit ;

■ à déposer une colle sur les flancs des tranchées ainsi réalisées; et

■ à rapprocher les flancs des tranchées de manière à fermer celle-ci.

On entend ici des circuits d'épaisseur inférieure au millimètre, par exemple une épaisseur allant de 50 micromètres à 1 millimètre.

On notera que le rôle d'un substrat, composant usuel d'un circuit, sur lequel est fabriqué l'ensemble des composants électroniques en technologie couches minces (la couche disposée sur le substrat et comprenant ces composants est communément appelée « couche active »), a pour unique but d'assurer la tenue mécanique du circuit, et donc permettre la manipulation de celui-ci à chaque étape de sa fabrication. Eliminer le substrat pour n'en conserver qu'une faible épaisseur sous la couche active rend la manipulation du circuit en cours de fabrication très difficile, au prix d'outils coûteux et délicats à mettre en oeuvre. Cette problématique de préhension des dispositifs très fins (< 50 $\mu$m) est traitée dans le document intitulé "3D and TSV Report: Cost, Technologies and Market", publié par Yole Développement, mise à jour de novembre 2007, pp.186-203.

En d'autres termes, le fond des tranchées définissent des lignes de « fragilisation» permettant de plier le circuit à leur endroit et donc de courber le circuit. En outre, en ayant ôté de la matière, lorsque le circuit est courbé par le rapprochement des flancs des tranchées, il n'y a pas de formation des bourrelets ou de déchirures. Ainsi, le circuit peut être réalisé avec une épaisseur élevée lui conférant une bonne tenue mécanique. Enfin prévoir des tranchées de section triangulaire permet de parfaitement fermer celle-ci et ainsi obtenir une portion annulaire dans le plan perpendiculaire aux tranchées.

Selon une caractéristique avantageuse du procédé de l'invention, la largeur des tranchées est choisie de manière à satisfaire la relation :

$$L_{inf} = L_{sup} \times \left(1 - \frac{W}{R_c}\right)$$

expression dans laquelle :

L$_{inf}$ est longueur d'un arc de cercle formé par la face du circuit dans laquelle sont formées les tranchées une fois celles-ci fermées,

L$_{sup}$ est la longueur d'un arc de cercle formée par la face du circuit opposée à la face dans laquelle sont formées les tranchées lors que les tranchées sont fermées,

W est l'épaisseur du circuit, et

R$_c$ est le rayon de courbure souhaité pour le circuit.

En outre, l'épaisseur résiduelle du circuit au dessus du fond des tranchées est avantageusement inférieure à 50 micromètres, et la largeur desdites tranchées est supérieure ou égale à 100 micromètres.

Selon l'invention, la somme des largeurs des tranchées est avantageusement inférieure à 75% de la largeur de la face dans laquelle elles sont formées, afin de ne pas remettre le dispositif en état de fragilité, avec trop peu de substrat pour en assurer la tenue mécanique.

Enfin, la formation de tranchées peut être réalisée selon des directions différentes afin d'obtenir une courbure anisotrope du circuit.

## BREVE DESCRIPTION DES FIGURES

L'invention sera mieux comprise à la lecture de la description qui va suivre, donnée à titre d'exemple, et réalisée en relation avec les dessins annexés, dans lesquels des références identiques désignent des éléments identiques ou analogues fonctionnellement, et dans lesquels :

- les figures 1 à 5 sont des vues schématiques en section d'un circuit monolithique à différents stades du procédé selon l'invention ;
- la figure 6 est une vue schématique en section d'un circuit hybridé de l'état de la technique particulièrement adapté pour être courbé selon le procédé de l'invention ;
- la figure 7 est une vue schématique de dessus d'un circuit illustrant l'orientation de tranchées selon différentes directions.

## DESCRIPTION DETAILLEE DE L'INVENTION

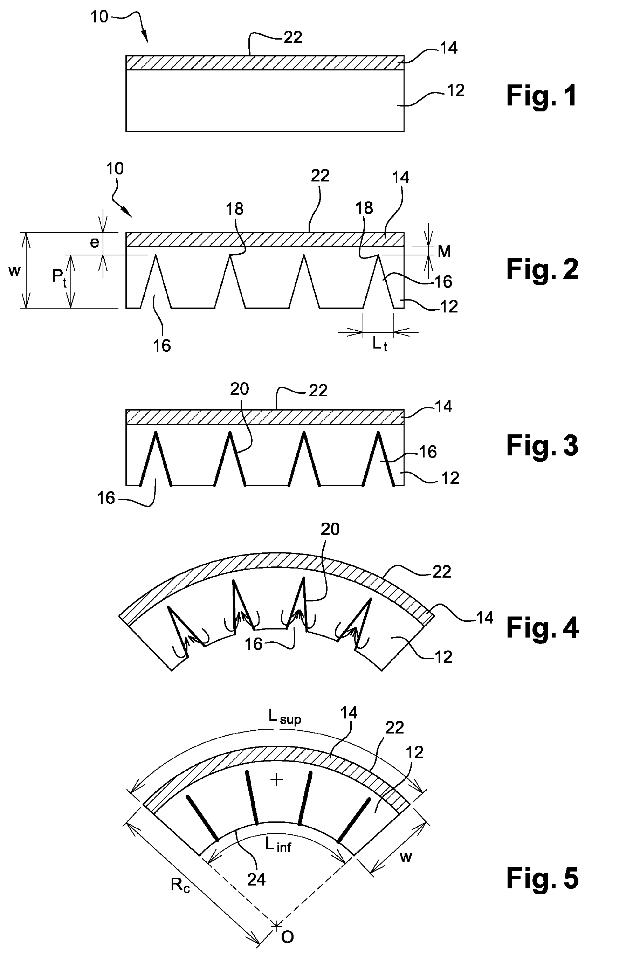

Sur la figure 1, un circuit électronique monolithique plan **10,** par exemple un capteur d'image réalisé en technologie CCD ou CMOS, comporte un substrat 12 en silicium formant support sur lequel est formée une couche dite « active » **14** comportant l'ensemble des éléments électroniques nécessaires à la formation et à la lecture d'images, comme cela est connu en soi de l'état de la technique. Le circuit plan **10** est réalisé à l'aide de techniques classiques qui ne seront pas décrites plus en détails pour des raisons de concision.

Selon l'invention, des tranchées **16** de section transversale triangulaire sont alors formées dans la face libre du substrat **12** (figure 2) et traversent de part en part ce dernier. Plus précisément, les tranchées débouchent de part et d'autre du circuit **10.** Les tranchées **16** sont réalisées à l'aide de techniques classiques, par exemple par découpage, gravure sèche ou humide, microfraisage, etc...

La forme et les dimensions des tranchées sont choisies pour à la fois obtenir la courbure souhaitées pour le circuit **10,** courbure non nécessairement en arc de cercle, et pour définir des lignes de « pliure » le long desquelles le circuit **10** se pliera ultérieurement de manière certaine pour obtenir la courbure souhaitée.

Plus particulièrement, lorsque la section des tranchées **16** est isocèle, la largeur $L_t$ des tranchées **16,** le nombre de tranchées **16,** ainsi que leur espacement, sont choisis pour obtenir une courbure en arc de cercle souhaitée pour le circuit **10.** La profondeur $P_t$ des tranchées **16** est quant à elle choisie pour régler l'épaisseur résiduelle e du circuit **10** au dessus du fond **18** des tranchées **16,** d'une manière qui sera expliquée plus en détail par la suite.

Le procédé selon l'invention se poursuit alors par le dépôt d'une colle **20,** par exemple de l'époxy, sur les flancs des tranchées **16** (figure 3). Le dépôt de colle est par exemple réalisé au moyen d'une seringue qui dispense de la colle à l'entrée des tranchées **16,** la colle migrant alors par capillarité dans lesdites tranchées, et par conséquent sur leurs flancs.

Une fois la colle **20** déposée sur le flanc des tranchées **16,** le circuit **10** est courbé afin de fermer les tranchées (figure 4). Par exemple, le circuit **10** est rapporté sur une membrane élastique, ou en un matériau à mémoire de forme, maintenue plate et reprenant lorsqu'elle est relâchée la forme attendue pour le circuit **10.**

Une telle membrane de forme sphérique, est par exemple décrite dans le document « A hemispherical electonic eye camera based on compressible silicon optoelectronics » de H. Cho KO et al, Nature, vol. 454, pp 748-753, août 2008. On notera que ce document divulgue une matrice de pixels reliés par des connexions souples et qu'il n'est pas décrit la courbure du substrat et du circuit de lecture nécessairement associés auxdits pixels et dont l'épaisseur est telle qu'ils ne peuvent être courbés directement à l'aide de la membrane, comme cela a été expliqué plus haut.

En reprenant sa forme, la membrane impose ainsi la fermeture des tranchées **16** et donc la courbure souhaitée pour le circuit **10,** à savoir, dans l'exemple illustré, une portion d'anneau sphérique de rayon $R_c$ dans le plan perpendiculaire à la direction de formation des tranchées (figure 5).

Pour obtenir une courbure en arc de cercle de rayon $R_c$ de la surface libre **22** de la couche active **14,** par exemple la surface de détection d'un capteur d'images, la forme et les dimensions des tranchées sont choisies pour que la relation suivante soit satisfaite :

$$L_{inf} = L_{sup} \times \left( 1 - \frac{W}{R_c} \right)$$

où :

$L_{inf}$ est longueur de la surface libre **24** du circuit **10** dirigée vers le centre de courbure $O$ du circuit **10** une fois celui-ci courbé, c'est-à-dire la surface libre du substrat **12** une fois le circuit **10** courbé (figure 5), $L_{sup}$ est la longueur de la surface libre **24** opposée à la surface **22,** c'est-à-dire celle de la couche **14,** et W est l'épaisseur du circuit **10.**

Dans le cas où le circuit **10** prend initialement la forme d'un parallélogramme rectangle, et en choisissant des tranchées identiques, de section triangulaire isocèle et d'espacement constant, comme cela est le cas de l'exemple illustré, la largeur $L_t$ est alors égale à :

$$L_t = \frac{L_{sup} - L_{inf}}{N}$$

où N est le nombre de tranchées.

La profondeur $P_t$ des tranchées **16** est quant à elle choisie de manière à ce que la hauteur résiduelle $e = W - P_t$ soit inférieure à 50 micromètres et supérieure à 15 micromètres. De cette manière, une souplesse du circuit **10** au niveau du fond **18** des tranchées est obtenue du fait de la faible épaisseur, sans pour autant risquer de déchirer le circuit.

Par ailleurs, la couche active **14** comportant les composants et connexions électroniques, il est préférable de laisser une marge $M$ entre le fond **18** des tranchées **16** d'une dizaine de micromètres pour ne pas risquer d'endommager lesdits composants et connexions électroniques lors de la formation des tranchées **16.**

A titre d'exemple numérique, pour un circuit **10** d'une épaisseur $W$ de 525 micromètres et d'une largeur $L_{sup}$ de 10 millimètres, ayant une couche active **14** de 25 micromètres, et dont on souhaite un rayon de courbure de 17,2 millimètres, il convient donc de répartir un total de 300 micromètres de tranchées **16,** soit par exemple trois tranchées de 100 micromètres chacune séparées d'une distance de 2425 micromètres.

De préférence, la largeur des tranchées est supérieure ou égale à 100 micromètres afin de pouvoir utiliser des seringues de l'état de la technique pour l'amenée de la colle **20** dans les tranchées.

De préférence également, la somme des largeurs des tranchées est inférieure à 75% à la largeur de la face dans laquelle elles sont formées, afin de ne pas remettre le dispositif en état de fragilité, avec trop peu de substrat pour en assurer la tenue mécanique.

Il a été décrit un mode de réalisation dans lequel une courbure en arc de cercle est obtenue à l'aide de tranchées identiques isocèles régulièrement réparties.

Bien entendu, des courbures différentes peuvent être obtenues en fonction des applications visées et/ou de contraintes de construction et d'assemblage. Par exemple, les tranchées peuvent avoir des largeurs différentes et/ou peuvent être espacées de manière non régulière.

De même, il a été décrit un mode de réalisation dans lequel un circuit monolithique, par exemple un capteur CCD ou CMOS dans lequel les éléments de détection sont intégrés à la couche active, notamment pour des questions de simplicité de câblage.

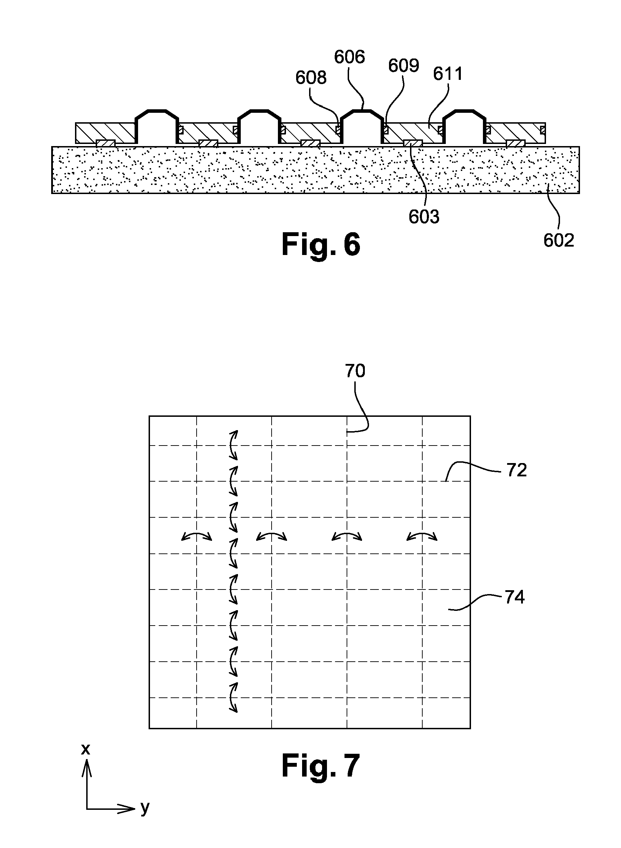

La présente invention s'applique cependant également aux circuits hybridés, et avantageusement à celui décrit dans la demande WO2008/007008 dont la figure 6d est ici reproduite à la figure 6.

Selon ce document, un dispositif électronique **620** comprend une pluralité de composants électroniques **611** rapportés sur un substrat **602**. Chaque composant **611** est mécaniquement relié au substrat **602** par l'intermédiaire d'un élément de liaison **603,** comme une bille de brasure par exemple. Chaque composant **611** est en outre électriquement connecté à au moins un composant adjacent au moyen d'au moins un conducteur **606**. Les conducteurs **606** présentent une élasticité susceptible de conserver l'intégrité de la connexion électrique avec un composant adjacent malgré un déplacement relatif entre composants.

Ayant réalisé un tel dispositif **620,** il est alors possible de le courber en mettant en oeuvre le procédé de la présente invention au substrat **602,** les conducteurs **606** étant suffisamment élastiques pour s'étirer sans se casser.

En variante, le substrat **602** est tout d'abord courbé selon l'invention puis les éléments **611** et leur conducteur **606** reportés ensuite sur le substrat courbé.

De même il a été décrit une courbure selon une seule direction. Bien entendu, l'invention permet de courber un circuit selon deux dimensions.

Par exemple, comme cela est illustré à la figure 7, un premier ensemble de tranchées **70** peut être réalisé selon une première direction *x*, et un second ensemble de tranchées **72** peut être réalisé selon une deuxième direction *y*, perpendiculaire à la première direction *x*.

En choisissant, des tranchées identiques et de même espacement pour les deux ensembles **70, 72,** il est ainsi obtenu un circuit prenant la forme d'une portion de sphère.

Une courbure anisotrope peut également être obtenue en choisissant des ensembles différents, par exemple ayant des tranchées différentes et/ou des espacements différents, auquel cas la courbure selon la première direction sera différente de la courbure selon la deuxième direction, comme cela est le cas de la figure 7.

De même, il est possible de choisir des tranchées formant, non pas un réseau de rectangles **74** comme illustré à la figure 7, mais un réseau de pentagones, d'hexagones, etc...

Grâce à l'invention, il est ainsi obtenu :

■ un circuit courbé d'épaisseur importante, ce qui simplifie notamment sa manipulation et évite sa dégradation en cas de contact avec des surfaces non homogènes ;

■ une courbure qui peut être isotrope ou non isotrope en fonction des applications visées ; et

■ un procédé qui n'impose pas de revoir la conception du circuit plan qui est courbé. En effet, le circuit peut être fabriqué selon les techniques usuelles puis courbé. Notamment, il n'est pas besoin de prévoir un traitement différencié pour la couche comprenant les éléments et connexions électroniques du circuit.

## Revendications

1. Procédé de réalisation d'un circuit courbé (10), *caractérisé* **en ce qu'**il consiste :

■ à former, dans une face (24) dudit circuit (10) et selon au moins une direction prédéterminée, des tranchées (16) de section transversale triangulaire, parallèles entre elles et débouchant de part et d'autre dudit circuit (10) ;
■ à déposer une colle (20) sur les flancs des tranchées (16) ainsi réalisées ; et
■ à rapprocher les flancs des tranchées (16) de manière à fermer celle-ci.

2. Procédé de réalisation d'un circuit courbé (10) selon la revendication 1, *caractérisé* **en ce que** la largeur des tranchées (16) est choisie de manière à satisfaire la relation :

$$ L_{\text{inf}} = L_{\text{sup}} \times \left( 1 - \frac{W}{R_c} \right) $$

où $L_{\text{inf}}$ est la longueur d'un arc de cercle formé par la face (24) du circuit (10) dans laquelle sont formées les tranchées (16) une fois celles-ci fermées, $L_{\text{sup}}$ est la longueur d'un arc de cercle formée par la face (22) du circuit opposée à la face (24) dans laquelle sont formées les tranchées lors que les tranchées sont fermées, W est l'épaisseur du circuit, et $R_c$ est le rayon de courbure souhaité pour le circuit.

3. Procédé de réalisation d'un circuit courbé (10) selon l'une des revendications 1 et 2, *caractérisé* **en ce que** l'épaisseur résiduelle (e) du circuit (10) au dessus du fond (18) des tranchées (16) est inférieure à 50 micromètres.

4. Procédé de réalisation d'un circuit courbé (10) selon l'une quelconque des revendications précédentes, *caractérisé* **en ce que** la largeur ($L_t$) des tranchées (16) est supérieure ou égale à 100 micromètres.

5. Procédé de réalisation d'un circuit courbé (10) selon l'une quelconque des revendications précédentes, *caractérisé* **en ce que** la somme des largeurs ($L_t$) des tranchées (16) est inférieure à 75% de la largeur de la face dans laquelle elles sont formées.

6. Procédé de réalisation d'un circuit courbé (10) selon l'une quelconque des revendications précédentes, *caractérisé* **qu'**il comporte la formation de tranchées selon des directions différentes afin d'obtenir une courbure anisotrope du circuit.

**Fig. 1**

**Fig. 2**

**Fig. 3**

**Fig. 4**

**Fig. 5**

608  606  609  611

603

602

**Fig. 6**

70

72

74

x

y

**Fig. 7**

Europäisches
Patentamt

European
Patent Office

Office européen
des brevets

## RAPPORT DE RECHERCHE EUROPEENNE

Numéro de la demande

EP 10 30 5911

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 2 065 490 A1 (SUMITOMO ELECTRIC INDUSTRIES [JP]) 3 juin 2009 (2009-06-03) * alinéa [0031] - alinéa [0032]; figure 1 * | 1-6 | INV. H01L31/0352 |
| A | EP 1 122 791 A2 (ASTRIUM GMBH [DE] EADS ASTRIUM GMBH [DE]) 8 août 2001 (2001-08-08) * alinéa [0032] - alinéa [0034]; figure 1 * | 1-6 | |

-----

-----

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| La Haye | 10 février 2011 | Franche, Vincent |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

& : membre de la même famille, document correspondant

EPO FORM 1503 03.82 (P04C02)

**EP 2 320 469 A1**

**ANNEXE AU RAPPORT DE RECHERCHE EUROPEENNE
RELATIF A LA DEMANDE DE BREVET EUROPEEN NO.**

EP 10 30 5911

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-02-2011

| Document brevet cité au rapport de recherche | | Date de publication | Membre(s) de la famille de brevet(s) | | Date de publication |
|---|---|---|---|---|---|
| EP 2065490 | A1 | 03-06-2009 | CN | 101441998 A | 27-05-2009 |
| | | | JP | 2009126727 A | 11-06-2009 |
| | | | KR | 20090052291 A | 25-05-2009 |
| | | | US | 2009127564 A1 | 21-05-2009 |
| EP 1122791 | A2 | 08-08-2001 | AT | 369627 T | 15-08-2007 |
| | | | DE | 10004891 A1 | 30-08-2001 |
| | | | JP | 2001284567 A | 12-10-2001 |
| | | | US | 2001020671 A1 | 13-09-2001 |

Pour tout renseignement concernant cette annexe : voir Journal Officiel de l'Office européen des brevets, No.12/82

## RÉFÉRENCES CITÉES DANS LA DESCRIPTION

**Documents brevets cités dans la description**

- WO 2008007008 A

**Littérature non-brevet citée dans la description**

- **Ivan Avratusky et al.** Concept of a miniature optical spectrometer using integrated optical and micro-optical components. *Applied Optics,* Octobre 2006, vol. 45 (30

- 3D and TSV Report: Cost, Technologies and Market. Yole Développement, Novembre 2007, 186-203
- **H. Cho KO et al.** A hemispherical electonic eye camera based on compressible silicon optoelectronics. *Nature,* Août 2008, vol. 454, 748-753